# EUROPÄISCHE PATENTSCHRIFT

(11) **EP 1 940 206 B1**
(45) Veröffentlichungstag und Bekanntmachung des Hinweises auf die Patenterteilung: **25.05.2011**
(21) Anmeldenummer: 07122232.7
(22) Anmeldetag: 04.12.2007
(51) Int. Cl.: H05K 1/11, H05K 3/32

(54) **Elektrische Vorrichtung mit zusammen verbundenen Leiterelementen**
Electric device with conductive elements bound together
Dispositif électrique avec éléments conducteurs reliés entre eux

(30) Priorität: 28.12.2006 DE 102006062493
(43) Veröffentlichungstag der Anmeldung: 02.07.2008
(73) Patentinhaber: ROBERT BOSCH GMBH, 70442 Stuttgart (DE)
(72) Erfinder: Hau, Wolfgang, 72555 Metzingen (DE); Huber, Daniel, 72762 Reutlingen (DE); Silberbauer, Achim, 72762 Reutlingen (DE); Dillmann, Adolf, 72525 Muensingen (DE)

(56) Entgegenhaltungen:
- EP-A- 0 297 388
- EP-A- 0 312 415
- DE-A1- 3 219 579
- DE-A1- 4 430 798
- DE-A1-102004 040 592

## Beschreibung

### Stand der Technik

Die Erfindung betrifft eine elektrische Vorrichtung mit einem Trägerteil aus einem Einbettungsmaterial, sowie mit ersten Leiterelementen, insbesondere gestanzten Leiterbahnen. Eine derartige elektrische Vorrichtung ist beispielsweise aus der DE 10 2004 040 592 A1 bekannt. So sei beispielsweise auf die dort offenbarte Figur 1 eingegangen, wobei dort verschiedene Bondverbindungen offenbart sind. Die Bonddrähte kontaktieren auf Bondpads die Leiter 25. Es wurde dabei festgestellt, dass sich durch das Bonden, das heißt durch das Verbinden der Bonddrähte mit den Leitern mittels hochfrequenter Schwingungen (Ultraschallschwingungen) unter Umständen ergibt, dass sich der im Kunststoff eingebettete Leiter lockert. Dies hat den Nachteil, dass unter Umständen bei kritischen Schwingungsanregungen eine übermäßige Belastung der Verbindungsstelle zwischen Leiter und Bonddraht auftritt und dadurch ein Ablösen des Bonddrahts möglich sein kann.

### Offenbarung der Erfindung

Die erfindungsgemäße elektrische Vorrichtung mit einem Trägerteil aus einem Einbettungsmaterial, sowie mit ersten Leiterelementen, insbesondere gestanzten Leiterbahnen, wobei die ersten Leiterelemente in dem Einbettungsmaterial des Trägerteils eingebettet sind, wobei die Vorrichtung des Weiteren mit zweiten Leiterelementen versehen ist, die mittels einer stoffschlüssigen Verbindung mit den ersten Leiterelementen an einer Verbindungsstelle verbunden sind und die Verbindungsstelle zu einer Einbettungsstelle benachbart ist, in der das erste Leiterelement vom Einbettungsmaterial mehr als drei Seiten umgriffen ist, hat den Vorteil, dass durch die Kontur, die das Einbettungsmaterial an der Verankerungsstelle hintergreift, eine deutlich bessere Verankerung des Leiterelements im Einbettungsmaterial erreicht wird und dadurch verminderte Haltekräfte zwischen Einbettungsmaterial und erstem Leiterelement, die durch Ultraschallschwingungen hervorgerufen werden, vermieden bzw. verhindert werden.

Ist das Leiterelement in der Verankerungsstelle in einer anderen Ebene angeordnet als an der Verbindungsstelle, so ergibt sich eine besonders hohe Materialstärke, die zur Verankerung des Leiterelements in der Einbettungsstelle dient. Die potentiell übertragbaren Haltekräfte an der Einbettungsstelle sind besonders hoch.

Erfolgt ein Übergang des ersten Leiterelements von der Verbindungsstelle zur Verankerungsstelle durch eine Stufe im ersten Leiterelement, so ist die Haltewirkung in dem Abschnitt des Leiterelements, das in der Einbettungsstelle angeordnet ist, besonders gut. Es ergibt sich hier ein besonderer Formschluss, der ein Lösen des Leiterelements in der Einbettungsstelle aus der Einbettungsstelle heraus nur mit Gewalt ermöglicht.

Soll die Verankerungsstelle mit besonders wenig Raumbedarf durchgeführt werden, so kann der Übergang im ersten Leiterelement von der Verbindungsstelle zur Verankerungsstelle stufenlos erfolgen. Ist zwischen der Verankerungsstelle und einer Zuleitung die Verbindungsstelle angeordnet, so ergibt sich insbesondere im Zusammenhang mit freien Enden des Leiterelements im Bereich der Einbettungsstelle eine gute Verankerung der Verbindungsstelle, obwohl die Einbettung des Leiters nur auf kurzer Strecke erfolgt. Unter Umständen kann es sich bei besonders knappem Raumangebot anbieten, dass sich zwei Einbettungsstellen gegenüber liegen, die zwischen sich die Verbindungsstelle einschließen. Ist die Einbettungsstelle zwischen der Verbindungsstelle und einer Öffnung im Trägerteil, so kann trotz einer nur kurzen Länge des Leiterelements zwischen Verbindungsstelle und Öffnung eine gute Einbettung des Leiterelements im Einbettungsmaterial erreicht werden. Dies gilt ganz besonders, wenn das erste Leiterelement in der Öffnung aus einer Wandung heraustritt. Dann sind die Haltekräfte im Einbettungsmaterial üblicherweise sehr gering, wobei durch die Anordnung der Einbettungsstelle im Bereich der Wandung dann ein Lösen des Leiterelements im Einbettungsmaterial verhindert wird. Weist das erste Leiterelement an der Verbindungsstelle einen ersten Querschnitt auf und in einer Wandungsebene (Öffnung) einen zweiten Querschnitt, wobei der erste Querschnitt größer als der zweite Querschnitt ist, so ergibt sich in der Wandungsebene bzw. kurz davor sowohl ein verbesserter Formschluss des Leiterelements und des Weiteren sind geringe Stanzkräfte am eingebetteten Leiter erforderlich. Wird ein solches Leiterelement üblicherweise über eine Öffnung hinaus geleitet, dieses ist beispielsweise in einem der Verfahrensstadien zur Herstellung einer solchen Vorrichtung üblich, so muss vor der Positionierung von diversen Bauteilen in dieser Öffnung ein Teil dieses Stanzgitters entfernt werden. Dies wird üblicherweise durch Stanzen in der Öffnung ermöglicht. Werden dabei die Querschnitte besonders klein gewählt, so sind die Kräfte im eingebetteten Material (Gegenkräfte !) besonders klein. Dies unterstützt die Wirkung der Einbettungsstelle, so dass das Leiterelement weiter verbessert im Einbettungsmaterial gehalten wird.

### Kurze Beschreibung der Zeichnungen

Im Folgenden wird die Erfindung anhand einiger Figuren näher erläutert.

Es zeigen:
- Figur 1: eine Ausschnittansicht einer elektrischen Vorrichtung,
- Figur 2: in einem Teilquerschnitt einen Kühlkörper in einer Öffnung,
- Figur 2A: eine Detailansicht,
- Figur 3: ein weiteres Ausführungsbeispiel für ein Leiterelement,
- Figur 3A und 3B: die in Figur 3 eingezeichneten Querschnitte durch das Leiterelement,
- Figur 4: weitere Ausführungsbeispiele für zweite Leiterelemente,
- Figur 4A: eine Seitenansicht auf ein erstes Leiterelement,
- Figur 5: das Leiterelement aus Figur 4 und 4A in eingebettetem Zustand im Trägerteil,
- Figur 6: in einem weiteren Ausführungsbeispiel ein Leiterelement, bei dem zwei Verbindungsstellen miteinander einstückig verbunden sind,
- Figur 7A und 7B: ist je ein weiteres Ausführungsbeispiel für ein Leiterelement dargestellt,
- Figur 8: schematisch eine elektrische Vorrichtung mit einem Trägerteil und einem ersten Leiterelement und einem zweiten Leiterelement.

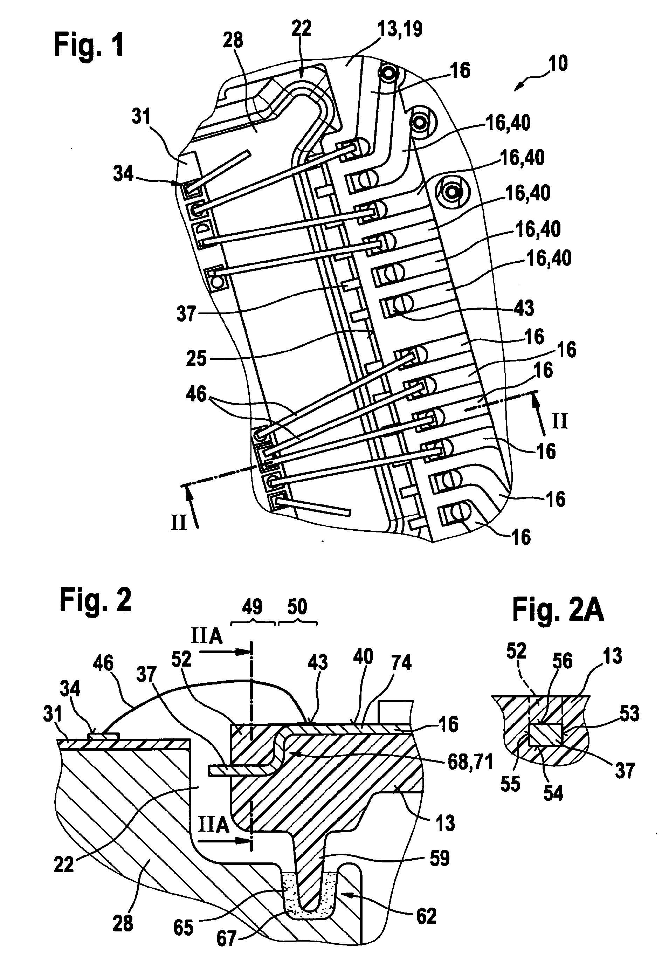

Figur 1 zeigt eine Ausschnittansicht einer elektrischen Vorrichtung 10, die ein Trägerteil 13 aufweist, in dem etliche Leiterelemente 16 eingebettet sind. Das Trägerteil 13 besteht aus einem Einbettungsmaterial 19, das beispielsweise ein spritzgegossener Kunststoff sein kann. Das Trägerteil 13 weist eine Öffnung 22 auf, deren Umrandung durch eine Wandung 25 begrenzt ist. In der Öffnung 22 ist ein Kühlkörper 28 eingesetzt, auf dessen im Wesentlichen planer Oberfläche ein Elektronikmodul 31 befestigt ist. Dieses Elektronikmodul 31 ist beispielsweise ein Reglerchip oder eine andere elektronische Vorrichtung. Auf der Oberfläche des Elektronikmoduls 31 befinden sich verschiedene Anschlussflächen 34 (Bondpads), die eine Kontaktierung des Elektronikmoduls 31 erlauben. Die Leiterelemente 16 sind beispielsweise als gestanzte Leiterbahnen ausgeführt und somit aus einem größeren einstückigen Blechteil herausgearbeitet. Die Leiterelemente 16 sind hier als erste Leiterelemente 16 bezeichnet. Die Leiterelemente 16 enden gemäß der Darstellung in Figur 1 mit ihren freien Enden 37 in der Öffnung 22. Die ersten Leiterelemente 16 weisen Oberflächenabschnitte 40 auf, die in diesem Beispiel in derselben Ebene angeordnet sind, wie die Oberfläche des Trägerteils 13, siehe auch Figur 2. Die ersten Leiterelemente 16 weisen jeweils kurz vor der Öffnung 22 einen Flächenabschnitt 43 auf, der als Anschlussfläche der ersten Leiterelemente 16 dient. Zwischen einer Anschlussfläche 34 und einem Flächenabschnitt 43 ist, wie in Figur 2 dargestellt, unter Umständen eine sogenannte Bondverbindung verwirklicht. Eine derartige Bondverbindung besteht aus einem zweiten Leiterelement 46 (Bonddraht), der einerseits eine stoffschlüssige Verbindung mit einer Anschlussfläche 34 aufweist und andererseits eine stoffschlüssige Verbindung mit einem Flächenabschnitt 43 auf einem Leiterelement 16 hat.

Figur 2 zeigt in einem Teilquerschnitt den Kühlkörper 28 und das darauf angeordnete Elektronikmodul mit der Anschlussfläche 34, von dem ein Bonddraht (zweites Leiterelement 46) zum Flächenabschnitt 43 verläuft. Wie deutlich zu erkennen ist, weist das Leiterelement 16 an einer Verankerungsstelle 49 eine Kontur auf, so dass das Leiterelement nicht nur an mehr als drei Seiten von Einbettungsmaterial 19 umgriffen ist, sondern zudem von Einbettungsmaterial hintergriffen ist. Das Hintergreifen von Einbettungsmaterial 19 durch das erste Leiterelement 16 führt dazu, dass ein Querriegel 52 vorhanden ist, der das erste Leiterelement 16 somit auch an einer vierten Seite umgreift. Die vier Seiten sind deutlich in Figur 2A a zu erkennen: Die erste Seite trägt das Bezugszeichen 53, die zweite Seite das Bezugszeichen 54, die dritte Seite das Bezugszeichen 55, die vierte Seite das Bezugszeichen 56. Der Abschnitt des Querriegels 52 ist in Figur 2a schematisch durch die gestrichelten Linien begrenzt.

Wird bei der Befestigung des zweiten Leiterelements 46 eine Sonotrode des Ultraschallschweißgeräts auf dem Flächenabschnitt 43 hin und her bewegt, um die nötige Reibungswärme zu erzeugen, die letztlich zur stoffschlüssigen Verbindung zwischen Leiterelement und Flächenabschnitt 43 führt, so wird auf das Einbettungsmaterial 19 eine für die Einbettungssicherheit des ersten Leiterelements 16 relevante Kraft ausgeübt. Um die Relativbewegungen zwischen dem Einbettungsmaterial 19 und dem ersten Leiterelement 16 so gering wie möglich zu halten, ist unterhalb der Flächenabschnitte 43 vorgesehen, dass das Trägerteil 13 durch eine Rippe 59 verstärkt ist. Diese Rippe 59 führt dazu, dass eine Querstabilität unterhalb der Flächenabschnitte 43, die in Figur 1 in einer Linie orientiert sind, zu erheblicher Versteifung führt. Diese Rippe 59 dient als Anbindung für eine Klebeverbindung 62, die zwischen der Rippe 59 und einer Rinne 65 mittels Klebstoff 67 hergestellt ist. Es ist somit eine elektrische Vorrichtung 10 offenbart, die ein Trägerteil 13 aus einem Einbettungsmaterial 19 aufweist. In dem Einbettungsmaterial 19 des Trägerteils 13 sind erste Leiterelemente 16 eingebettet, die insbesondere aus gestanzten Leiterbahnen bestehen. Des Weiteren weist die elektrische Vorrichtung 10 zweite Leiterelemente 46 (Bonddrähte) auf, die mittels einer stoffschlüssigen Verbindung (Schweißverbindung, Ultraschallschweißverbindung) mit den ersten Leiterelementen 16 mit einer Verbindungsstelle 50 verbunden sind. Die Verbindungsstelle 50 ist einer Verankerungsstelle 49 benachbart. In dieser Verankerungsstelle 49 ist das erste Leiterelement 16 von Einbettungsmaterial 19 an mehr als drei Seiten 53, 54, 55 umgriffen. Das erste Leiterelement 16 weist an der Verankerungsstelle 49 eine Kontur auf, die Einbettungsmaterial 19 hintergreift.

Wie aus der Figur 2 ersichtlich ist, ist das Leiterelement 16 in der Verankerungsstelle 49 in einer anderen Ebene angeordnet als an der Verbindungsstelle 50. Ein Übergang 68 des ersten Leiterelements 16 von der Verbindungsstelle 50 zur Verankerungsstelle 49 erfolgt durch eine Stufe 71 im ersten Leiterelement 16.

Die Verbindungsstelle 50 ist zwischen der Verankerungsstelle 49 und einer Zuleitung 74 angeordnet.

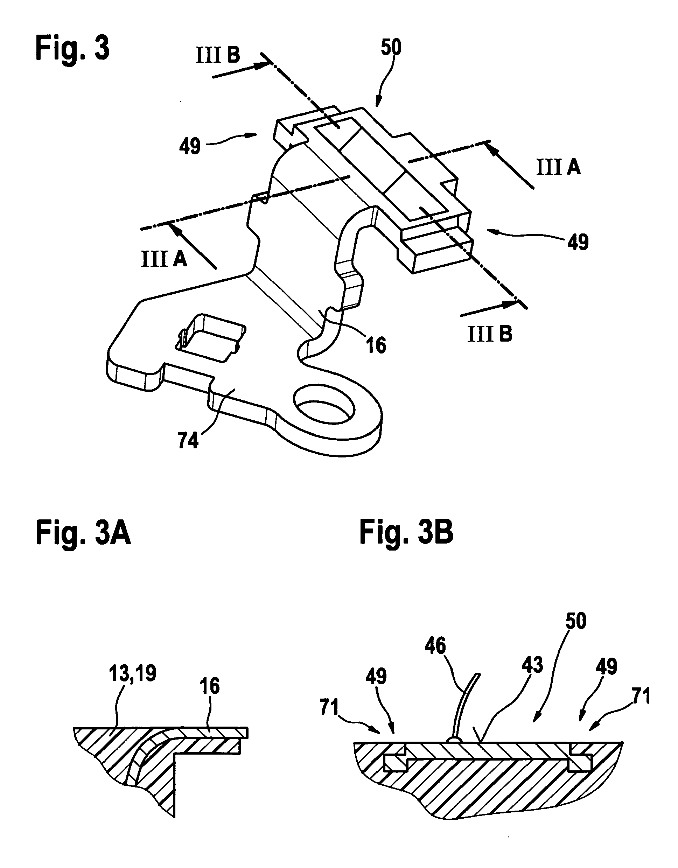

Figur 3 zeigt ein weiteres Ausführungsbeispiel für ein Leiterelement 16, wobei das Einbettungsmaterial 19 nicht dargestellt ist. Das Leiterelement 16 weist hier ebenfalls eine Verbindungsstelle 50 auf, die für die Kontaktierung mit einem Bonddraht bzw. zweiten Leiterelement 46 vorgesehen ist. Im Ausführungsbeispiel nach Figur 3 nehmen zwei Verankerungsstellen 49 eine Verbindungsstelle 50 zwischen sich auf. In diesem Fall ist die Zuleitung 74 so angeordnet, dass diese an der Verbindungsstelle 50 endet und dort zwischen den beiden Verankerungsstellen 49 angeordnet ist. Es liegen somit zwei Verankerungsstellen einander gegenüber, die zwischen sich die Verbindungsstelle 50 einschließen.

Wie in Figur 2 deutlich zu erkennen ist, ist eine Verankerungsstelle 49 zwischen einer Verbindungsstelle 50 und einer Öffnung 22 im Trägerteil 13 angeordnet. Dort tritt auch das erste Leiterelement 16 in die Öffnung 22 aus der Wandung 25 heraus. Die Figuren 3A und 3B zeigen die in Figur 3 eingezeichneten Querschnitte durch das Leiterelement 16 und das Einbettungsmaterial 19 des Trägerteils 13. In Figur 3B ist zu erkennen, wie die Verbindungsstelle 50 mit ihrem Flächenelement 43 zwischen zwei Verankerungsstellen 49 angeordnet ist.

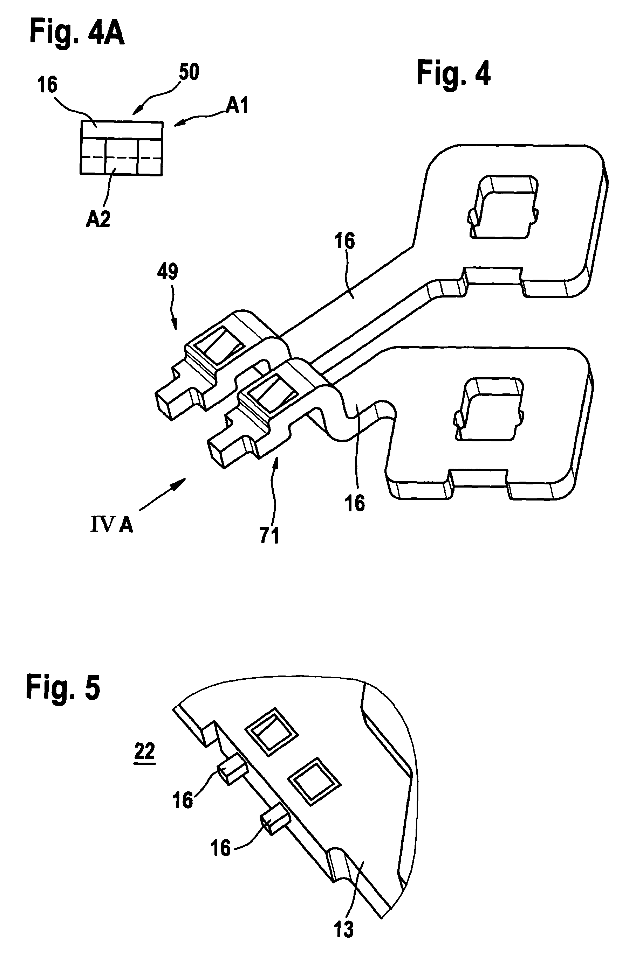

In Figur 4 ist ein weiteres Ausführungsbeispiel für zweite Leiterelemente 16 dargestellt. Auch hier ist die Verankerungsstelle 49 mit einer Stufe 71 ausgeführt.
In Figur 4A ist eine Seitenansicht dargestellt. Wie aus dieser Seitenansicht hervorgeht, zeigt das erste Leiterelement 16 an der Verbindungsstelle 50 einen ersten Querschnitt A1 und in einer Wandungsebene einen zweiten Querschnitt A2. Der erste Querschnitt A1 ist größer als der zweite Querschnitt A2. Figur 5 zeigt das Leiterelement aus Figur 4 und 4A in eingebettetem Zustand im Trägerteil 13. Es ist deutlich zu erkennen, wie die Leiterenden 37 in der Öffnung 22 enden bzw. in diese hineinragen.

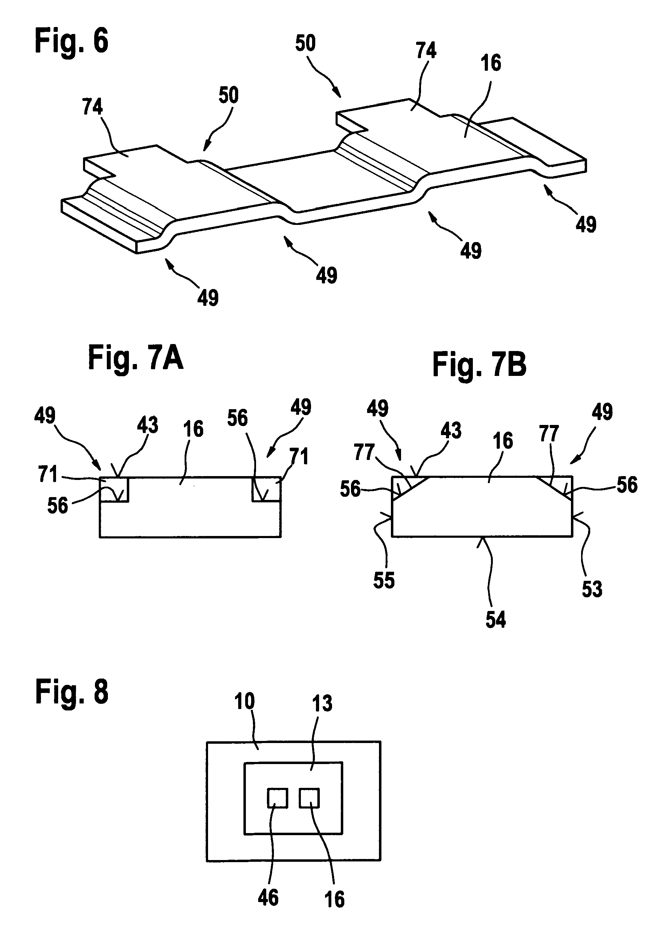

Figur 6 zeigt in einem weiteren Ausführungsbeispiel ein Leiterelement 16, bei dem zwei Verbindungsstellen 50 miteinander einstückig verbunden sind. Beide Verbindungsstellen 50 sind beiderseits mittels einer Verankerungsstelle 49 im hier nicht dargestellten Einbettungsmaterial 19 des Trägerteils 13 verankert. In Figur 7A ist ein weiteres Ausführungsbeispiel für ein Leiterelement 16 mit einer Verankerungsstelle 49 dargestellt. In diesem Fall weist das Leiterelement 16 an seinen beiden äußeren oberen Kanten Einbuchtungen bzw. Stufen 71 auf, die beispielsweise durch plastisches Verformen des Leiterelements 16 entstanden sind. Bettet man nun diesen Leitern 16 mit diesen beiden Stufen 71 in dem Trägerteil 13 ein, so erhält das Einbettungsmaterial 19 Gelegenheit, die Stufen 71 auszufüllen. Dadurch entsteht ebenfalls ein Hintergriff bzw. eine Hinterschneidung, so dass das erste Leiterelement 16 gut und sicher im Trägerteil 13 eingebettet ist. In Figur 7B ist analog zum Ausführungsbeispiel in Figur 7A ebenfalls ein Leiterelement 16 dargestellt. Im Unterschied zum obigen Ausführungsbeispiel weist dieses keine Stufen sondern Schrägen 77 auf, die einen stufenlosen Übergang von der Verbindungsstelle 50 zur Verankerungsstelle 49 ermöglichen. Figur 8 zeigt schematisch eine elektrische Vorrichtung 10 mit einem Trägerteil 13 und einem ersten Leiterelement 16 und einem zweiten Leiterelement 46.

## Patentansprüche

1. Elektrische Vorrichtung (10) mit einem Trägerteil (13) aus einem Einbettungsmaterial (19) sowie mit ersten Leiterelementen (16), insbesondere gestanzten Leiterbahnen, wobei die ersten Leiterelemente (16) in dem Einbettungsmaterial (19) des Trägerteils (13) eingebettet sind, desweiteren mit zweiten Leiterelementen (46), wobei die zweiten Leiterelemente (46) mittels einer stoffschlüssigen Verbindung mit den ersten Leiterelementen (16) an einer Verbindungsstelle (50) verbunden sind und die Verbindungsstelle (50) zu einer Verankerungsstelle (49) benachbart ist, in der das erste Leiterelement (16) von Einbettungsmaterial (19) an mehr als drei Seiten (53, 54, 55, 56) umgriffen ist, **dadurch gekennzeichnet, dass** das erste Leiterelement (16) an der Verankerungsstelle (49) eine Kontur aufweist, die Einbettungsmaterial (19) hintergreift, wobei das erste Leiterelement (16) an der Verbindungsstelle (50) einen ersten Querschnitt (A₁) aufweist und in einer Wandungsebene (25) einen zweiten Querschnitt (A₂) aufweist, wobei der erste Querschnitt (A1) größer als der zweite Querschnitt (A2) ist..

2. Elektrische Vorrichtung nach Anspruch 1, **dadurch gekennzeichnet, dass** das Leiterelement (16) in der Verankerungsstelle (49) in einer anderen Ebene angeordnet ist als an der Verbindungsstelle (50).

3. Elektrische Vorrichtung nach Anspruch 1 oder 2, **dadurch gekennzeichnet, dass** ein Übergang des ersten Leiterelement (16) von der Verbindungsstelle (50) zur Verankerungsstelle (49) durch eine Stufe (71) im ersten Leiterelement (16) erfolgt.

4. Elektrische Vorrichtung nach Anspruch 1 oder 2, **dadurch gekennzeichnet, dass** ein Übergang des ersten Leiterelements (16) von der Verbindungsstelle (50) zur Verankerungsstelle (49) im ersten Leiterelement (16) stufenlos erfolgt.

5. Elektrische Vorrichtung nach einem der vorstehenden Ansprüche, **dadurch gekennzeichnet, dass** zwischen der Verankerungsstelle (49) und einer Zuleitung (74) die Verbindungsstelle (50) angeordnet ist.

6. Elektrische Vorrichtung nach Anspruch 5, **dadurch gekennzeichnet, dass** sich zwei Verankerungsstellen (49) gegenüber liegen, die zwischen sich die Verbindungsstelle (50) einschließen.

7. Elektrische Vorrichtung nach einem der vorstehenden Ansprüche, dass eine Verankerungsstelle (49) zwischen der Verbindungsstelle (50) und einer Öffnung (22) im Trägerteil (13) ist.

8. Elektrische Vorrichtung nach Anspruch 7, **dadurch gekennzeichnet, dass** das erste Leiterelement (16) in der Öffnung (22) aus einer Wandung (25) heraustritt.

## Claims

1. Electrical device (10) comprising a carrier part (13) composed of an embedding material (19) and also comprising first conductor elements (16), in particular stamped conductor tracks, wherein the first conductor elements (16) are embedded in the embedding material (19) of the carrier part (13), furthermore comprising second conductor elements (46), wherein the second conductor elements (46) are connected by means of a cohesive connection to the first conductor elements (16) at a connection location (50) and the connection location (50) is adjacent to an anchoring location (49), in which the first conductor element (16) is encompassed by embedding material (19) at more than three sides (53, 54, 55, 56), **characterized in that** the first conductor element (16) has at the anchoring location (49) a contour which engages behind embedding material (19), wherein the first conductor element (16) has a first cross section (A₁) at the connection location (50) and has a second cross section (A₂) in a wall plane (25), wherein the first cross section (A₁) is larger than the second cross section (A₂).

2. Electrical device according to Claim 1, **characterized in that** the conductor element (16) is arranged in a different plane in the anchoring location (49) and at the connection location (50).

3. Electrical device according to Claim 1 or 2, **characterized in that** a transition of the first conductor element (16) from the connection location (50) to the anchoring location (49) takes place through a step (71) in the first conductor element (16).

4. Electrical device according to Claim 1 or 2, **characterized in that** a transition of the first conductor element (16) from the connection location (50) to the anchoring location (49) takes place in a stepless manner in the first conductor element (16).

5. Electrical device according to any of the preceding claims, **characterized in that** the connection location (50) is arranged between the anchoring location (49) and a lead (74).

6. Electrical device according to Claim 5, **characterized in that** two anchoring locations (49) lie opposite each other and enclose the connection location (50) between them.

7. Electrical device according to any of the preceding claims, **characterized in that** there is an anchoring location (49) between the connection location (50) and an opening (22) in the carrier part (13).

8. Electrical device according to Claim 7, **characterized in that** the first conductor element (16) emerges from a wall (25) in the opening (22).

## Revendications

1. Dispositif électrique (10) doté d'une partie de support (13) en un matériau d'incorporation (19) ainsi que de premiers éléments conducteurs (16), en particulier des pistes conductrices estampées, les premiers éléments conducteurs (16) étant incorporés dans le matériau d'incorporation (19) de la partie de support (13),
et présentant en outre des deuxièmes éléments conducteurs (46), les deuxièmes éléments conducteurs (46) étant reliés en un emplacement de liaison (50) aux premiers éléments conducteurs (16) au moyen d'une liaison en correspondance de matière, l'emplacement de liaison (50) étant voisin d'un emplacement d'ancrage (49) dans lequel le premier élément conducteur (16) est saisi par le matériau d'incorporation (19) sur plus de trois côtés (53, 54, 55, 56),
**caractérisé en ce que**
le premier élément conducteur (16) présente sur l'emplacement d'ancrage (49) un contour qui chevauche par l'arrière le matériau d'incorporation (19), le premier élément conducteur (16) présentant à l'emplacement de liaison (50) une première section transversale (A₁) et dans un plan de paroi (25) une deuxième section transversale (A₂), la première section transversale (A1) étant plus grande que la deuxième section transversale (A2).

2. Dispositif électrique selon la revendication 1, **caractérisé en ce que** l'élément conducteur (16) est disposé dans l'emplacement d'ancrage (49) dans un autre plan que l'emplacement de liaison (50).

3. Dispositif électrique selon les revendications 1 ou 2, **caractérisé en ce qu'**une transition du premier élément conducteur (16) entre l'emplacement de liaison (50) et l'emplacement d'ancrage (49) s'effectue par un gradin (71) ménagé dans le premier élément conducteur (16).

4. Dispositif électrique selon les revendications 1 ou 2, **caractérisé en ce qu'**une transition du premier élément conducteur (16) entre l'emplacement de liaison (50) et l'emplacement d'ancrage (49) s'effectue sans gradin.

5. Dispositif électrique selon l'une des revendications précédentes, **caractérisé en ce que** l'emplacement de liaison (50) est disposé entre l'emplacement d'ancrage (49) et un premier conducteur d'amenée (74).

6. Dispositif électrique selon la revendication 5, **caractérisé en ce que** deux emplacements d'ancrage (49) qui forment entre eux l'emplacement de liaison (50) sont situés l'un en face de l'autre.

7. Dispositif électrique selon l'une des revendications précédentes, **caractérisé en ce qu'**un emplacement d'ancrage (49) est situé entre l'emplacement de liaison (50) et une ouverture (22) ménagée dans la partie de support (13).

8. Dispositif électrique selon la revendication 7, **caractérisé en ce que** le premier élément conducteur (16) sort d'une paroi (25) dans l'ouverture (22).
